# EUROPEAN PATENT APPLICATION

(11) **EP 4 130 335 A1**
(43) Date of publication of application: **08.02.2023**
(21) Application number: 21781717.0
(22) Date of filing: 18.03.2021
(51) Int. Cl.: C23C 16/455, C23C 16/40, H01L 21/316

(54) **MATERIAL FOR FORMATION OF THIN FILM FOR USE IN ATOMIC LAYER DEPOSITION AND METHOD FOR PRODUCING THIN FILM**

(30) Priority: 01.04.2020 JP 2020065624
(71) Applicant: ADEKA CORPORATION, Arakawa-ku Tokyo 116-8554 (JP)
(72) Inventor: TAKEDA, Keisuke, Tokyo 116-8554 (JP); ENZU, Masaki, Tokyo 116-8554 (JP)
(74) Representative: Müller-Boré & Partner Patentanwälte PartG mbB
(86) International application number: PCT/JP2021/011088
(87) International publication number: WO 2021/200218

(57) **Abstract**

Provided is a thin-film forming raw material, which is used in an atomic layer deposition method, including a compound represented by the following formula (1): 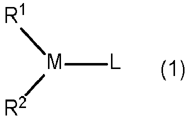 where R¹ and R² each independently represent a hydrogen atom or an alkyl group having 1 to 5 carbon atoms, L represents a group represented by the following formula (L-1) or (L-2), and M represents an indium atom or a gallium atom; 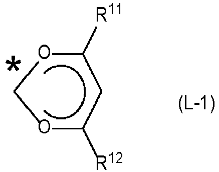 where R¹¹ and R¹² each independently represent a hydrogen atom, a fluorine atom, an alkyl group having 1 to 5 carbon atoms, or an alkoxy group having 1 to 5 carbon atoms, and * represents a bonding position with M in the formula (1); 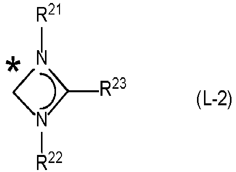 where R²¹ to R²³ each independently represent a hydrogen atom, a fluorine atom, or an alkyl group having 1 to 5 carbon atoms, and * represents a bonding position with M in the formula (1), provided that R²¹ and R²² represent different groups.

## Description

### Technical Field

The present invention relates to a thin-film forming raw material, which is used in an atomic layer deposition method, including a gallium compound or an indium compound having a specific structure, and to a method of producing a thin-film containing a gallium atom or an indium atom through use of the thin-film forming raw material.

### Background Art

A thin-film forming raw material including a gallium element or an indium element shows specific electrical characteristics, and hence its applications to, in particular, uses in optoelectronics, such as a semiconductor element, a solar cell, and an LED, have become significant.

Examples of a method of producing a thin-film include a sputtering method, an ion plating method, metal organic decomposition (MOD) methods, such as a coating thermal decomposition method and a sol-gel method, and a chemical vapor deposition (CVD) method. Of those, an atomic layer deposition (ALD) method that is one kind of chemical vapor deposition method is an optimum production process because the method has such many advantages as described below. The method is excellent in composition controllability and step coverage, is suitable for mass production, and enables hybrid integration.

Various materials that can be used in thin-film formation methods, such as the CVD method and the ALD method, have been reported. However, in a thin-film forming raw material applicable to the ALD method, it is required that a temperature region called an ALD window be sufficiently wide. Accordingly, it is common general technical knowledge in the art that even a thin-film forming raw material, which can be used in the CVD method, may not be suitable for the ALD method in many cases.

In Patent Document 1, there is a disclosure that an oxide film may be formed by using trimethylgallium, triethylgallium, trimethylindium, or the like as a thin-film forming raw material, which is used in an atomic layer deposition method. In Patent Document 2, there is a proposal of a production method in which a metal thin-film is formed by using an indium dialkylamidinate, an indium dialkylguanidinate, or the like. In Patent Document 3, there is a disclosure that an indium-containing thin-film may be formed by a MOCVD method through use of a β-diketonato indium complex. In Patent Document 4, there is a proposal of a method of forming a film of gallium-doped silicon nitride through use of a metal precursor, such as gallium chloride, trimethylgallium, triethylgallium, tris(dimethylamino)gallium, tris(diethylamino)gallium, or tris(ethylmethylamino)gallium.

### Citation List

### Patent Document

Patent Document 1: JP 2014-099601 A
Patent Document 2: KR 10-1221861 B1
Patent Document 3: JP 2002-538082 A
Patent Document 4: JP 2018-528615 A

### Summary of Invention

### Technical Problem

A thin-film forming raw material, which is used in an atomic layer deposition method, has been required to be excellent in thermal stability and to be capable of producing a high-quality thin-film. It has been difficult for each of the compounds disclosed in Patent Documents 1 and 2, such as a trialkylgallium, a trialkylindium, an indium dialkylamidinate, an indium dialkylguanidinate, and a gallium trihalide, to form a high-quality thin-film through use of an ALD method because the compounds each have insufficient thermal stability. In addition, in Patent Document 3, no reference is made to whether or not the β-diketonato indium complex may be applied to the ALD method. In Patent Document 4, there is a description that a gallium nitride layer is deposited by the ALD method through use of trimethylgallium. However, it has been difficult for trimethylgallium to form a high-quality thin-film because of its insufficient thermal stability.

Accordingly, an object of the present invention is to provide a thin-film forming raw material, which is used in an atomic layer deposition method, including a compound excellent in thermal stability and being capable of producing a high-quality thin-film, and a method of producing a thin-film through use of the thin-film forming raw material.

### Solution to Problem

The inventors of the present invention have made extensive investigations, and as a result, have found that a thin-film forming raw material, which is used in an atomic layer deposition method, including a gallium compound or an indium compound having a specific structure, can solve the above-mentioned problems. Thus, the inventors have reached the present invention.

That is, according to one embodiment of the present invention, there is provided a thin-film forming raw material, which is used in an atomic layer deposition method, including a compound represented by the following general formula (1):

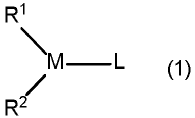

In the formula (1), R¹ and R² each independently represent a hydrogen atom or an alkyl group having 1 to 5 carbon atoms, L represents a group represented by the following general formula (L-1) or (L-2), and M represents an indium atom or a gallium atom, and part or all of hydrogen atoms in the alkyl group may each be substituted with a fluorine atom.

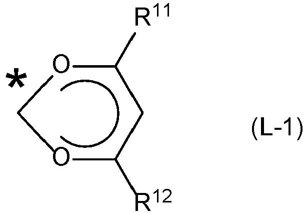

In the formula (L-1), R¹¹ and R¹² each independently represent a hydrogen atom, a fluorine atom, an alkyl group having 1 to 5 carbon atoms, or an alkoxy group having 1 to 5 carbon atoms, and * represents a bonding position with M in the general formula (1), and part or all of hydrogen atoms in the alkyl group may each be substituted with a fluorine atom.

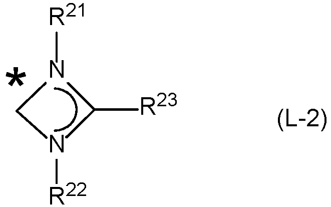

In the formula (L-2), R²¹ to R²³ each independently represent a hydrogen atom, a fluorine atom, or an alkyl group having 1 to 5 carbon atoms, and * represents a bonding position with M in the general formula (1), provided that R²¹ and R²² represent different groups, and part or all of hydrogen atoms in the alkyl group may each be substituted with a fluorine atom.

According to another embodiment of the present invention, there is provided a method of producing a thin-film containing an indium atom or a gallium atom on a surface of a substrate, the method including the steps of: adsorbing the compound in a raw material gas, which is obtained by vaporizing the thin-film forming raw material, which is used in an atomic layer deposition method, onto the surface of the substrate, to form a precursor thin-film; and subjecting the precursor thin-film to a reaction with a reactive gas, to form the thin-film containing an indium atom or a gallium atom on the surface of the substrate.

### Advantageous Effects of Invention

According to the present invention, there can be provided the thin-film forming raw material, which is used in an atomic layer deposition method, including a compound excellent in thermal stability and being capable of producing a high-quality thin-film. In addition, the thin-film forming raw material, which is used in an atomic layer deposition method, of the present invention enables the formation of a high-quality thin-film by an ALD method.

### Brief Description of Drawings

FIG. 1 is a schematic diagram for illustrating an example of an ALD apparatus to be used in a method of producing a thin-film according to the present invention.
FIG. 2 is a schematic diagram for illustrating another example of the ALD apparatus to be used in the method of producing a thin-film according to the present invention.
FIG. 3 is a schematic diagram for illustrating still another example of the ALD apparatus to be used in the method of producing a thin-film according to the present invention.
FIG. 4 is a schematic diagram for illustrating yet still another example of the ALD apparatus to be used in the method of producing a thin-film according to the present invention.

### Description of Embodiments

A thin-film forming raw material, which is used in an atomic layer deposition method, of the present invention contains a compound represented by the above-mentioned general formula (1).

In the general formula (1), examples of the alkyl group having 1 to 5 carbon atoms, which is represented by each of R¹ and R², include a methyl group, an ethyl group, a n-propyl group, an isopropyl group, a n-butyl group, a sec-butyl group, a tert-butyl group, an isobutyl group, a n-pentyl group, a sec-pentyl group, a tert-pentyl group, an isopentyl group, and a neopentyl group. Examples of the alkyl group in which part or all of hydrogen atoms are substituted with a fluorine atom include a fluoromethyl group, a difluoromethyl group, a trifluoromethyl group, a fluoroethyl group, a difluoroethyl group, a trifluoroethyl group, a pentafluoroethyl group, a fluoropropyl group, a heptafluoropropyl group, a fluoropentyl group, and an undecylfluoropentyl group.

Examples of the alkyl group having 1 to 5 carbon atoms, which is represented by each of R¹¹, R¹², and R²¹ to R²³ in the groups represented by the general formulae (L-1) and (L-2), include the same groups as those represented by R¹ and R² in the general formula (1).

Examples of the alkoxy group having 1 to 5 carbon atoms, which is represented by each of R¹¹ and R¹² in the group represented by the general formula (L-1), include a methoxy group, an ethoxy group, an isopropoxy group, a butoxy group, a sec-butoxy group, a tert-butoxy group, an isobutoxy group, a n-pentyloxy group, a sec-pentyloxy group, a tert-pentyloxy group, an isopentyloxy group, and a neopentyloxy group.

Compounds in which R¹ and R² in the general formula (1) represent methyl groups are preferred because the compounds have a low melting point and a high vapor pressure, and hence enable the formation of a thin-film with high productivity.

Although preferred specific examples of the compound represented by the general formula (1) include Compound No. 1 to Compound No. 80 below, the present invention is not limited by these compounds. In Compound No. 1 to Compound No. 80 below, the symbol "Me" represents a methyl group, the symbol "Et" represents an ethyl group, the symbol "iPr" represents an isopropyl group, the symbol "tBu" represents a tert-butyl group, and the symbol "CF₃" represents a trifluoromethyl group.

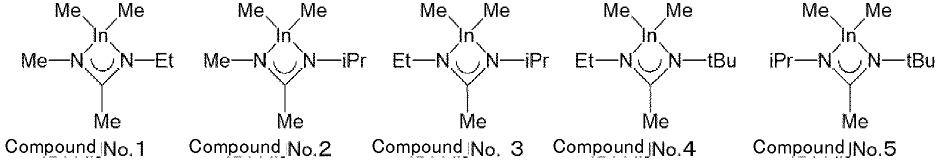

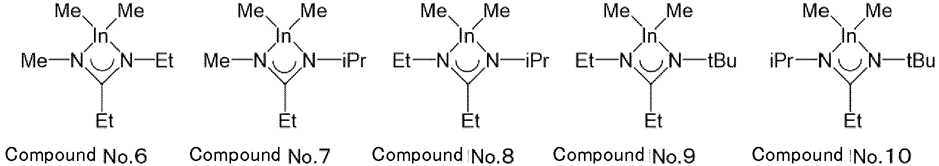

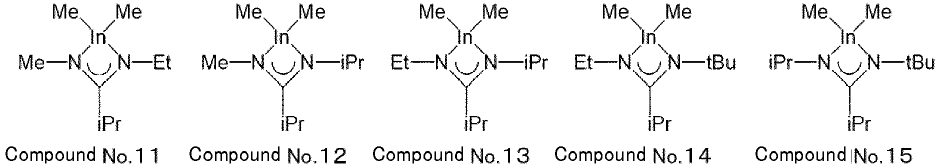

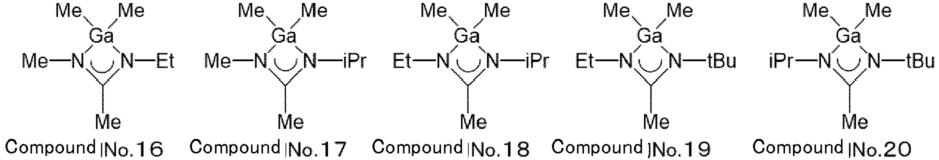

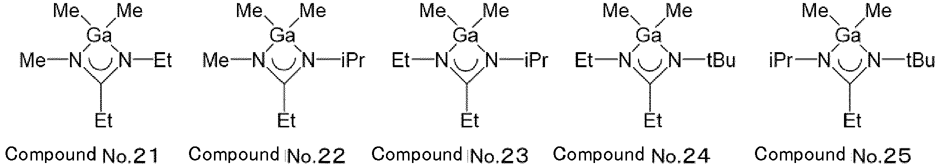

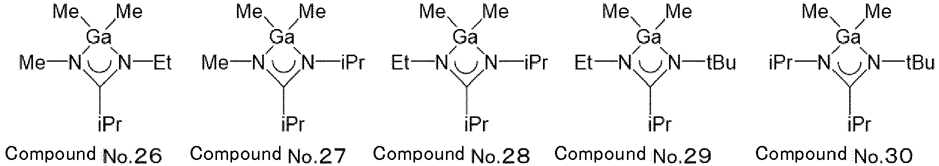

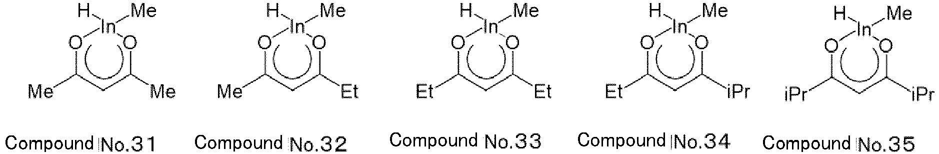

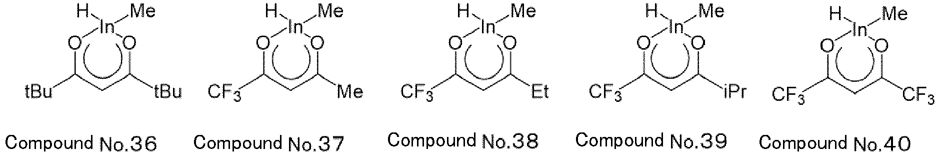

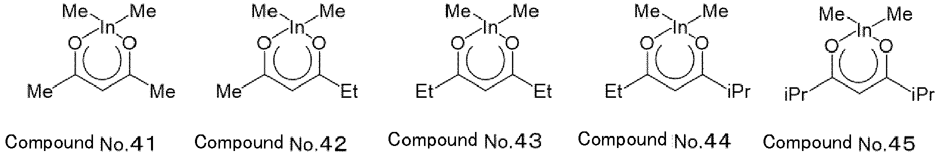

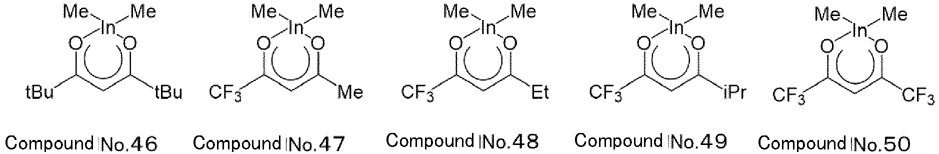

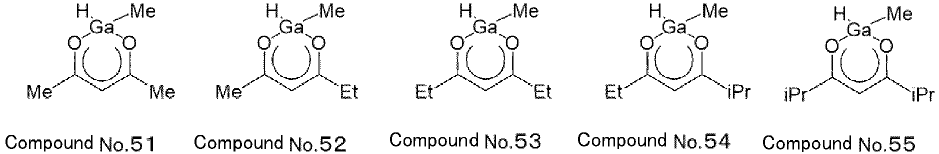

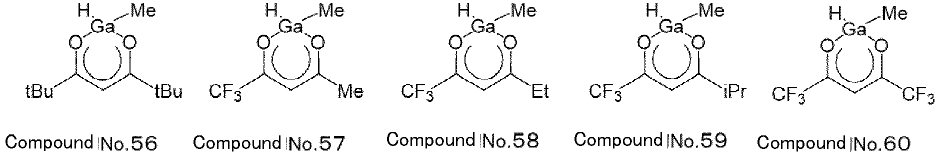

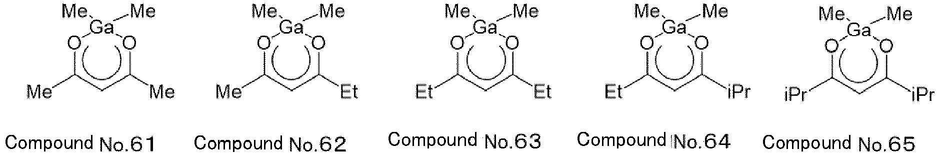

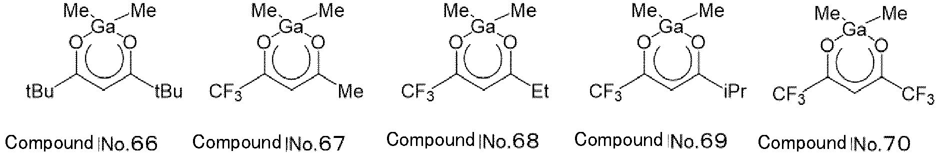

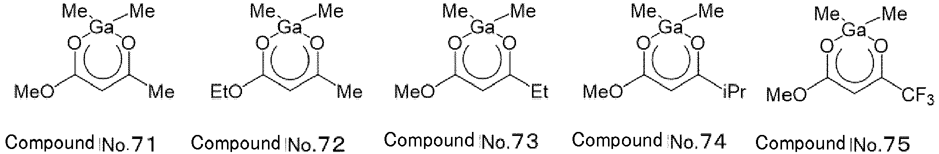

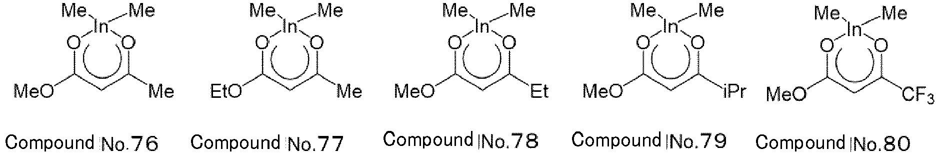

The compound represented by the general formula (1) may be produced by utilizing a well-known method. For example, a compound in which M represents indium, R¹ and R² represent methyl groups, and L represents a group represented by (L-1) may be obtained by: reacting trimethylindium with a β-diketone compound in a solvent; removing the solvent after the reaction; and purifying the residue through distillation. In addition, a compound in which M represents indium, R¹ and R² represent methyl groups, and L represents a group represented by (L-2) may be obtained by: reacting trimethylindium with a dialkylamidine compound in a solvent; removing the solvent after the reaction; and purifying the residue through distillation.

To secure transportability in a pipe in an ALD apparatus to be used at the time of the production of a thin-film through use of the thin-film forming raw material, which is used in an atomic layer deposition method, of the present invention, the melting point of the compound represented by the general formula (1) is preferably less than 100°C, and the compound is more preferably a liquid at normal temperature.

It is only required that the thin-film forming raw material, which is used in an atomic layer deposition method, of the present invention contain the compound represented by the general formula (1), and the composition thereof varies depending on the kind of an intended thin-film. For example, when a thin-film containing only gallium or indium as a metal is produced, the thin-film forming raw material, which is used in an atomic layer deposition method, of the present invention is free of a compound of a metal other than gallium and indium and a semimetal compound. Meanwhile, when a thin-film containing a metal other than gallium and indium and/or a semimetal is produced, the thin-film forming raw material, which is used in an atomic layer deposition method, of the present invention may contain a compound containing a desired metal and/or a compound containing a semimetal (hereinafter referred to as "other precursor") in addition to the compound represented by the general formula (1). In addition, the thin-film forming raw material, which is used in an atomic layer deposition method, of the present invention may further contain an organic solvent and/or a nucleophilic reagent as described later.

The form of the thin-film forming raw material, which is used in an atomic layer deposition method, of the present invention is appropriately selected by a procedure such as a transportation and supply method of the atomic layer deposition method to be used.

As the above-mentioned transportation and supply method, there are given a gas transportation method and a liquid transportation method. The gas transportation method involves: vaporizing the thin-film forming raw material, which is used in an atomic layer deposition method, of the present invention stored in a container (hereinafter sometimes simply referred to as "raw material container") through heating and/or decompression, to thereby obtain a raw material gas; and introducing the raw material gas into a film formation chamber (hereinafter sometimes referred to as "deposition reaction portion") having a substrate set therein together with a carrier gas, such as argon, nitrogen, or helium, to be used as required. The liquid transportation method involves: transporting the thin-film forming raw material, which is used in an atomic layer deposition method, of the present invention to a vaporization chamber under a state of a liquid or a solution; vaporizing the raw material in the vaporization chamber through heating and/or decompression, to thereby obtain a raw material gas; and introducing the raw material gas into the film formation chamber. In the case of the gas transportation method, the compound represented by the general formula (1) itself may be used as the thin-film forming raw material, which is used in an atomic layer deposition method. In the case of the liquid transportation method, the compound represented by the general formula (1) itself or a solution obtained by dissolving the compound in an organic solvent may be used as the thin-film forming raw material, which is used in an atomic layer deposition method, of the present invention. Those thin-film forming raw materials, which are used in an atomic layer deposition method, may each further contain the other precursor, a nucleophilic reagent, and the like.

In addition, in a multi-component ALD method, there are given a method involving vaporizing and supplying the thin-film forming raw material, which is used in an atomic layer deposition method, independently for each component (hereinafter sometimes referred to as "single source method"), and a method involving vaporizing and supplying a mixed raw material obtained by mixing a multi-component raw material with desired composition in advance (hereinafter sometimes referred to as "cocktail source method"). In the case of the cocktail source method, a mixture of the compound represented by the general formula (1) and the other precursor or a mixed solution obtained by dissolving the mixture in an organic solvent may be used as the thin-film forming raw material, which is used in an atomic layer deposition method, of the present invention. Those thin-film forming raw materials, which are used in an atomic layer deposition method, may each further contain a nucleophilic reagent and the like.

There is no particular limitation on the above-mentioned organic solvent, and a well-known general organic solvent may be used. Examples of the organic solvent include: acetic acid esters, such as ethyl acetate, butyl acetate, and methoxyethyl acetate; ethers, such as tetrahydrofuran, tetrahydropyran, ethylene glycol dimethyl ether, diethylene glycol dimethyl ether, triethylene glycol dimethyl ether, dibutyl ether, and dioxane; ketones, such as methyl butyl ketone, methyl isobutyl ketone, ethyl butyl ketone, dipropyl ketone, diisobutyl ketone, methyl amyl ketone, cyclohexanone, and methylcyclohexanone; hydrocarbons, such as hexane, cyclohexane, methylcyclohexane, dimethylcyclohexane, ethylcyclohexane, heptane, octane, toluene, and xylene; hydrocarbons each having a cyano group, such as 1-cyanopropane, 1-cyanobutane, 1-cyanohexane, cyanocyclohexane, cyanobenzene, 1,3-dicyanopropane, 1,4-dicyanobutane, 1,6-dicyanohexane, 1,4-dicyanocyclohexane, and 1,4-dicyanobenzene; and pyridine and lutidine. Those organic solvents may be used alone or as a mixture thereof depending on the solubility of a solute, the relationship among the use temperature, the boiling point, and the flash point, and the like.

When the above-mentioned organic solvent is used in the thin-film forming raw material, which is used in an atomic layer deposition method, of the present invention, the amount of the entire precursors in the thin-film forming raw material, which is used in an atomic layer deposition method, the raw material being a solution obtained by dissolving the precursors in the organic solvent, is preferably set to from 0.01 mol/liter to 2.0 mol/liter, in particular, from 0.05 mol/liter to 1.0 mol/liter. When the thin-film forming raw material, which is used in an atomic layer deposition method, of the present invention is free of any precursor other than the compound represented by the general formula (1), the amount of the entire precursors refers to the amount of the compound represented by the general formula (1). When the thin-film forming raw material, which is used in an atomic layer deposition method, of the present invention contains any other precursor in addition to the compound represented by the general formula (1), the amount of the entire precursors refers to the total amount of the compound represented by the general formula (1) and the other precursor.

In addition, in the case of the multi-component ALD method, there is no particular limitation on the other precursor to be used together with the compound represented by the general formula (1), and well-known general precursors used in the thin-film forming raw material, which is used in an atomic layer deposition method, may be used.

Examples of the other precursor include compounds of: one kind or two or more kinds selected from the group consisting of compounds used as organic ligands, such as an alcohol compound, a glycol compound, a β-diketone compound, a cyclopentadiene compound, and an organic amine compound; and silicon or a metal. In addition, examples of the kind of the metal in the precursor include lithium, sodium, potassium, magnesium, calcium, strontium, barium, titanium, zirconium, hafnium, vanadium, niobium, tantalum, chromium, molybdenum, tungsten, manganese, iron, osmium, ruthenium, cobalt, rhodium, iridium, nickel, palladium, platinum, copper, silver, gold, zinc, aluminum, gallium, indium, germanium, lead, antimony, bismuth, radium, scandium, ruthenium, yttrium, lanthanum, cerium, praseodymium, neodymium, promethium, samarium, europium, gadolinium, terbium, dysprosium, holmium, erbium, thulium, ytterbium, and lutetium.

Examples of the alcohol compound to be used as the organic ligand in the above-mentioned other precursor include: alkyl alcohols, such as methanol, ethanol, propanol, isopropyl alcohol, butanol, sec-butyl alcohol, isobutyl alcohol, tert-butyl alcohol, pentyl alcohol, isopentyl alcohol, and tert-pentyl alcohol; ether alcohols, such as 2-methoxyethanol, 2-ethoxyethanol, 2-butoxyethanol, 2-(2-methoxyethoxy)ethanol, 2-methoxy-1-methylethanol, 2-methoxy-1,1-dimethylethanol, 2-ethoxy-1,1-dimethylethanol, 2-isopropoxy-1,1-dimethylethanol, 2-butoxy-1,1-dimethylethanol, 2-(2-methoxyethoxy)-1,1-dimethylethanol, 2-propoxy-1,1-diethylethanol, 2-sec-butoxy-1,1-diethylethanol, and 3-methoxy-1,1-dimethylpropanol; and dialkylamino alcohols, such as dimethylaminoethanol, ethylmethylaminoethanol, diethylaminoethanol, dimethylamino-2-pentanol, ethylmethylamino-2-pentanol, dimethylamino-2-methyl-2-pentanol, ethylmethylamino-2-methyl-2-pentanol, and diethylamino-2-methyl-2-pentanol.

Examples of the glycol compound to be used as the organic ligand in the above-mentioned other precursor include 1,2-ethanediol, 1,2-propanediol, 1,3-propanediol, 2,4-hexanediol, 2,2-dimethyl-1,3-propanediol, 2,2-diethyl-1,3-propanediol, 1,3-butanediol, 2,4-butanediol, 2,2-diethyl-1,3-butanediol, 2-ethyl-2-butyl-1,3-propanediol, 2,4-pentanediol, 2-methyl-1,3-propanediol, 2-methyl-2,4-pentanediol, 2,4-hexanediol, and 2,4-dimethyl-2,4-pentanediol.

Examples of the β-diketone compound to be used as the organic ligand in the above-mentioned other precursor include: alkyl-substituted β-diketones, such as acetylacetone, hexane-2,4-dione, 5-methylhexane-2,4-dione, heptane-2,4-dione, 2-methylheptane-3,5-dione, 5-methylheptane-2,4-dione, 6-methylheptane-2,4-dione, 2,2-dimethylheptane-3,5-dione, 2,6-dimethylheptane-3,5-dione, 2,2,6-trimethylheptane-3,5-dione, 2,2,6,6-tetramethylheptane-3,5-dione, octane-2,4-dione, 2,2,6-trimethyloctane-3,5-dione, 2,6-dimethyloctane-3,5-dione, 2,9-dimethylnonane-4,6-dione, 2-methyl-6-ethyldecane-3,5-dione, and 2,2-dimethyl-6-ethyldecane-3,5-dione; fluorine-substituted alkyl β-diketones, such as 1,1,1-trifluoropentane-2,4-dione, 1,1,1-trifluoro-5,5-dimethylhexane-2,4-dione, 1,1,1,5,5,5-hexafluoropentane-2,4-dione, and 1,3-diperfluorohexylpropane-1,3-dione; and ether-substituted β-diketones, such as 1,1,5,5-tetramethyl-1-methoxyhexane-2,4-dione, 2,2,6,6-tetramethyl-1-methoxyheptane-3,5-dione, and 2,2,6,6-tetramethyl-1-(2-methoxyethoxy)heptane-3,5-dione.

Examples of the cyclopentadiene compound to be used as the organic ligand in the above-mentioned other precursor include cyclopentadiene, methylcyclopentadiene, ethylcyclopentadiene, propylcyclopentadiene, isopropylcyclopentadiene, butylcyclopentadiene, secbutylcyclopentadiene, isobutylcyclopentadiene, tertbutylcyclopentadiene, dimethylcyclopentadiene, and tetramethylcyclopentadiene.

Examples of the organic amine compound to be used as the organic ligand in the above-mentioned other precursor include methylamine, ethylamine, propylamine, isopropylamine, butylamine, sec-butylamine, tert-butylamine, isobutylamine, dimethylamine, diethylamine, dipropylamine, diisopropylamine, ethylmethylamine, propylmethylamine, and isopropylmethylamine.

The above-mentioned other precursors are known in the art, and production methods therefor are also known. For example, when the alcohol compound is used as the organic ligand, the precursor may be produced through a reaction between an inorganic salt of the metal described above or a hydrate thereof and an alkali metal alkoxide of the alcohol compound. In this case, examples of the inorganic salt of the metal or the hydrate thereof may include a halide and a nitrate of the metal. Examples of the alkali metal alkoxide may include a sodium alkoxide, a lithium alkoxide, and a potassium alkoxide.

In the case of the single source method, the above-mentioned other precursor is preferably a compound which is similar to the compound represented by the general formula (1) in the behavior of thermal decomposition and/or oxidative decomposition. In the case of the cocktail source method, the above-mentioned other precursor is preferably a compound which is similar to the compound represented by the general formula (1) in the behavior of thermal decomposition and/or oxidative decomposition, and in addition, which causes no change through a chemical reaction or the like at the time of mixing.

In addition, the thin-film forming raw material, which is used in an atomic layer deposition method, of the present invention may contain a nucleophilic reagent as required in order to improve the stability of each of the compound represented by the general formula (1) and the other precursor. Examples of the nucleophilic reagent include: ethylene glycol ethers, such as glyme, diglyme, triglyme, and tetraglyme; crown ethers, such as 18-crown-6, dicyclohexyl-18-crown-6, 24-crown-8, dicyclohexyl-24-crown-8, and dibenzo-24-crown-8; polyamines, such as ethylenediamine, N,N'-tetramethylethylenediamine, diethylenetriamine, triethylenetetramine, tetraethylenepentamine, pentaethylenehexamine, 1,1,4,7,7-pentamethyldiethylenetriamine, 1,1,4,7,10,10-hexamethyltriethylenetetramine, and triethoxytriethyleneamine; cyclic polyamines, such as cyclam and cyclen; heterocyclic compounds, such as pyridine, pyrrolidine, piperidine, morpholine, N-methylpyrrolidine, N-methylpiperidine, N-methylmorpholine, tetrahydrofuran, tetrahydropyran, 1,4-dioxane, oxazole, thiazole, and oxathiolane; β-keto esters, such as methyl acetoacetate, ethyl acetoacetate, and 2-methoxyethyl acetoacetate; and β-diketones, such as acetylacetone, 2,4-hexanedione, 2,4-heptanedione, 3,5-heptanedione, and dipivaloylmethane. The usage amount of each of those nucleophilic reagents falls within preferably the range of from 0.1 mol to 10 mol, more preferably the range of from 1 mol to 4 mol with respect to 1 mol of the amount of the entire precursors.

The thin-film forming raw material, which is used in an atomic layer deposition method, of the present invention is prevented from containing impurity metal elements other than the components forming the raw material, impurity halogens such as impurity chlorine, and impurity organic substances to the extent possible. The content of each of the impurity metal elements is preferably 100 ppb or less, more preferably 10 ppb or less, and the total content thereof is preferably 1 ppm or less, more preferably 100 ppb or less. In particular, when the raw material is used as a gate insulating film, a gate film, or a barrier layer of an LSI, it is required to reduce the contents of alkali metal elements and alkaline-earth metal elements that influence the electrical characteristics of a thin-film to be obtained. The content of the impurity halogens is preferably 100 ppm or less, more preferably 10 ppm or less, still more preferably 1 ppm or less. The total content of the impurity organic substances is preferably 500 ppm or less, more preferably 50 ppm or less, still more preferably 10 ppm or less. In addition, moisture causes generation of particles in the thin-film forming raw material, which is used in an atomic layer deposition method, and generation of particles during thin-film formation, and hence it is better to remove moisture in the precursor, the organic solvent, and the nucleophilic reagent as much as possible in advance at the time of use in order to reduce moisture in each of the precursor, the organic solvent, and the nucleophilic reagent. The moisture content of each of the precursor, the organic solvent, and the nucleophilic reagent is preferably 10 ppm or less, more preferably 1 ppm or less.

In addition, it is preferred that the thin-film forming raw material, which is used in an atomic layer deposition method, of the present invention be prevented from containing particles to the extent possible in order to reduce or prevent particle contamination of a thin-film to be formed. Specifically, in particle measurement with a light scattering liquid particle detector in a liquid phase, it is preferred that the number of particles larger than 0.3 um be 100 or less in 1 mL of the liquid phase, it is more preferred that the number of particles larger than 0.2 um be 1,000 or less in 1 mL of the liquid phase, and it is still more preferred that the number of particles larger than 0.2 µm be 100 or less in 1 mL of the liquid phase.

A method of producing a thin-film of the present invention is based on an ALD method involving using the above-mentioned thin-film forming raw material, which is used in an atomic layer deposition method, and the method includes the steps of: introducing a raw material gas obtained by vaporizing the thin-film forming raw material, which is used in an atomic layer deposition method, into a film formation chamber (treatment atmosphere) (raw material gas introduction step); adsorbing a gallium compound or an indium compound in the raw material gas onto the surface of a substrate, to form a precursor thin-film (precursor thin-film formation step); and introducing a reactive gas into the film formation chamber (treatment atmosphere), followed by causing the precursor thin-film and the reactive gas to react with each other, to thereby form a thin-film containing a gallium atom or an indium atom on the surface of the substrate (metal-containing thin-film formation step). In addition, the method includes a step of evacuating the gas in the film formation chamber (treatment atmosphere) (evacuation step) between the precursor thin-film formation step and the metal-containing thin-film formation step, and after the metal-containing thin-film formation step.

As a material for the substrate, there are given, for example: silicon; ceramics, such as silicon nitride, titanium nitride, tantalum nitride, titanium oxide, titanium nitride, ruthenium oxide, zirconium oxide, hafnium oxide, and lanthanum oxide; glass; and metals such as metal cobalt. The shape of the substrate is, for example, a plate shape, a spherical shape, a fibrous shape, or a scaly shape. The surface of the substrate may be planar, or may have a three-dimensional structure such as a trench structure.

In addition, as a method of introducing the raw material gas obtained by vaporizing the thin-film forming raw material, which is used in an atomic layer deposition method, into the film formation chamber in which the substrate is installed, there are given the above-mentioned gas transportation method, liquid transportation method, single source method, cocktail source method, and the like.

Examples of the reactive gas include: oxidizing gases, including oxygen, ozone, nitrogen dioxide, nitrogen monoxide, water vapor, hydrogen peroxide, formic acid, acetic acid, and acetic anhydride; reducing gases, including hydrogen; and nitriding gases, including organic amine compounds, such as a monoalkylamine, a dialkylamine, a trialkylamine, and an alkylenediamine, hydrazine, and ammonia. Those reactive gases may be used alone or as a mixture thereof. Of those gases, a gas containing oxygen, ozone, or water vapor is preferably used as the reactive gas because the thin-film forming raw material, which is used in an atomic layer deposition method, of the present invention satisfactorily reacts with oxygen, ozone, and water vapor at specifically low temperatures. A gas containing water vapor is more preferably used as the reactive gas because a high-quality thin-film having a small residual carbon amount can be produced with high productivity.

The method of producing a thin-film according to one embodiment of the present invention is described in detail by taking a case in which a gallium oxide thin-film is formed as an example. In the production method, the raw material gas introduction step, the precursor thin-film formation step, the evacuation step, the metal-containing thin-film formation step, and the other evacuation step are sequentially performed as one cycle, and the thickness of the thin-film can be adjusted by repeating the cycle. The respective steps of the method of producing a thin-film of the present invention are described below.

### (Raw Material Gas Introduction Step)

The raw material gas introduction step is a step of vaporizing the thin-film forming raw material, which is used in an atomic layer deposition method, of the present invention to provide the raw material gas, followed by the introduction of the raw material gas into the film formation chamber having set therein the substrate.

A temperature and a pressure at the time of the vaporization of the thin-film forming raw material, which is used in an atomic layer deposition method, preferably fall within the range of from 0°C to 200°C and the range of from 1 Pa to 10,000 Pa, respectively.

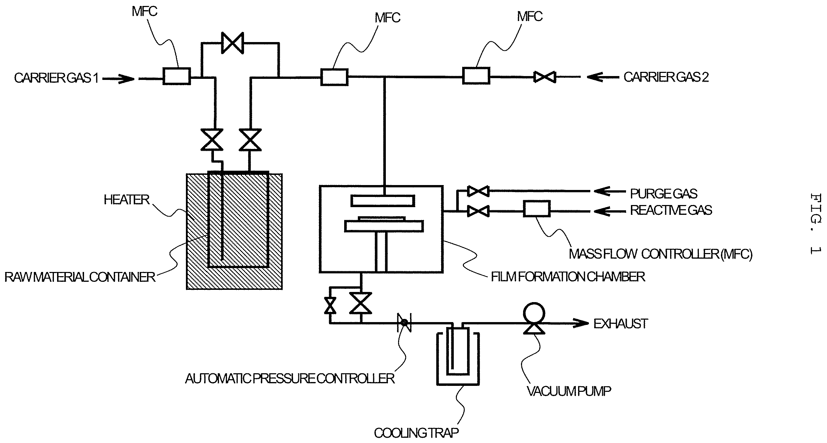

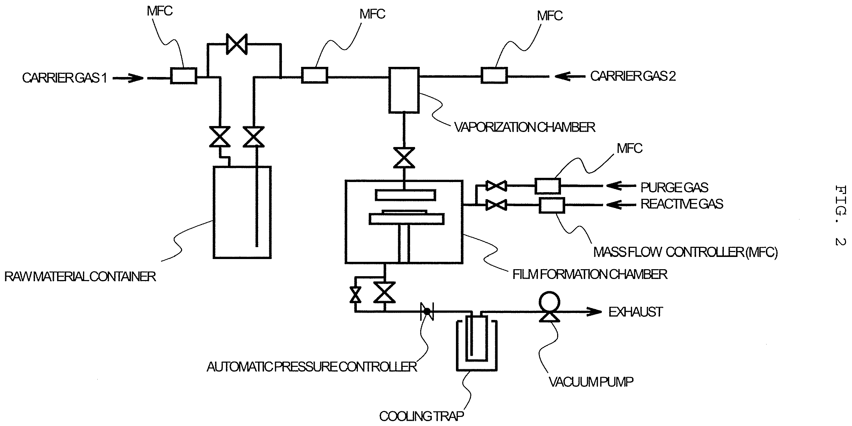

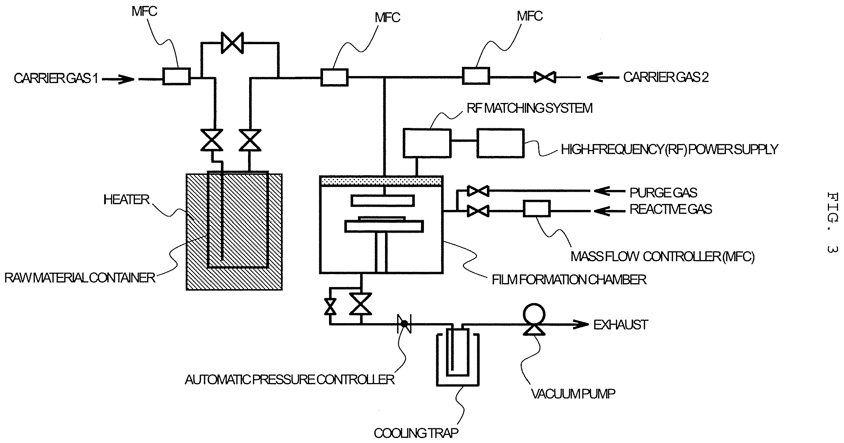

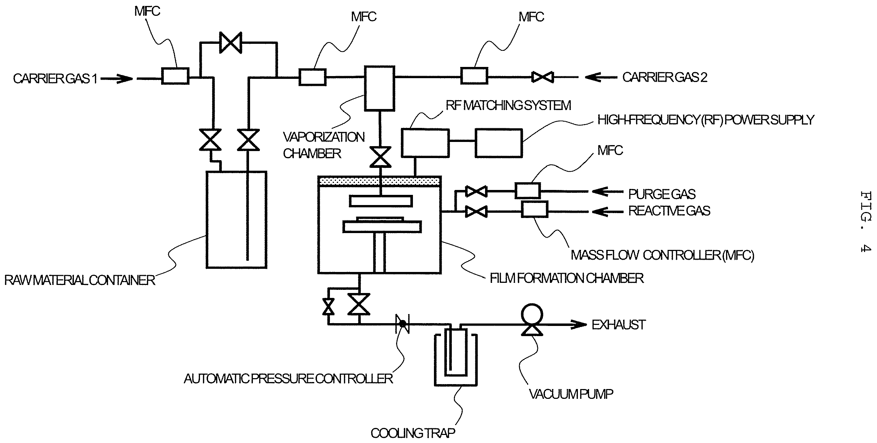

As the above-mentioned transportation and supply method for the thin-film forming raw material, which is used in an atomic layer deposition method, there are given a gas transportation method and a liquid transportation method. As illustrated in FIG. 1 and FIG. 3, the gas transportation method involves: vaporizing the thin-film forming raw material, which is used in an atomic layer deposition method, of the present invention stored in a container (hereinafter referred to as "raw material container") through heating and/or decompression, to thereby obtain a raw material gas; and introducing the raw material gas into a film formation chamber having a substrate set therein together with a carrier gas, such as argon, nitrogen, or helium, to be used as required. As illustrated in FIG. 2 and FIG. 4, the liquid transportation method involves: transporting the thin-film forming raw material, which is used in an atomic layer deposition method, of the present invention to a vaporization chamber under a state of a liquid or a solution; vaporizing the raw material in the vaporization chamber through heating and/or decompression, to thereby obtain a raw material gas; and introducing the raw material gas into the film formation chamber. In the case of the gas transportation method, the compound represented by the general formula (1) itself may be used as the thin-film forming raw material, which is used in an atomic layer deposition method. In the case of the liquid transportation method, the compound represented by the general formula (1) itself or a solution obtained by dissolving the compound in an organic solvent may be used as the thin-film forming raw material, which is used in an atomic layer deposition method. Those thin-film forming raw materials, which are used in an atomic layer deposition method, may each further contain a nucleophilic reagent and the like.

In addition, the above-mentioned single source method and cocktail source method may each be used as a method to be used in the raw material gas introduction step in addition to the above-mentioned gas transportation method and liquid transportation method. However, no matter which one of the introduction methods is used, the thin-film forming raw material, which is used in an atomic layer deposition method, of the present invention is preferably vaporized at from 0°C to 200°C. In addition, when the thin-film forming raw material, which is used in an atomic layer deposition method, is vaporized to obtain the raw material gas in the raw material container or in the vaporization chamber, the pressure in the raw material container and the pressure in the vaporization chamber each preferably fall within the range of from 1 Pa to 10,000 Pa.

As a material for the substrate to be set in the film formation chamber, there are given, for example: silicon; ceramics, such as silicon nitride, titanium nitride, tantalum nitride, titanium oxide, ruthenium oxide, zirconium oxide, hafnium oxide, and lanthanum oxide; glass; and metals such as metal ruthenium. The shape of the substrate is, for example, a plate shape, a spherical shape, a fibrous shape, or a scaly shape. The surface of the substrate may be planar, or may have a three-dimensional structure such as a trench structure.

### (Precursor Thin-film Formation Step)

In the precursor thin-film formation step, the compound represented by the general formula (1) in the raw material gas introduced into the film formation chamber having set therein the substrate is deposited on (caused to adsorb onto) the surface of the substrate to form the precursor thin-film on the surface of the substrate. At this time, heat may be applied by heating the substrate or by heating the inside of the film formation chamber. The conditions under which the precursor thin-film is formed are not particularly limited, and for example, a reaction temperature (substrate temperature), a reaction pressure, and a deposition rate may be appropriately determined in accordance with the kind of the thin-film forming raw material. The reaction temperature preferably falls within the range of from 0°C to 400°C, and more preferably falls within the range of from 150°C to 400°C, which are temperatures at which the thin-film forming raw material, which is used in an atomic layer deposition method, of the present invention sufficiently undergoes a reaction. The ALD window in the case where the thin-film forming raw material, which is used in an atomic layer deposition method, of the present invention and a reactive gas are used in combination falls within the range of from about 150°C to about 400°C. The reaction pressure is preferably from 1 Pa to 10,000 Pa, more preferably from 10 Pa to 1,000 Pa.

In addition, the above-mentioned deposition rate may be controlled by the conditions (a vaporization temperature and a vaporization pressure) under which the thin-film forming raw material, which is used in an atomic layer deposition method, is supplied, the reaction temperature, and the reaction pressure. The deposition rate is preferably from 0.005 nm/min to 100 nm/min, more preferably from 0.01 nm/min to 50 nm/min because of the following reasons: when the deposition rate is large, the characteristics of the thin-film to be obtained may deteriorate; and when the deposition rate is small, a problem in terms of productivity thereof may occur.

### (Evacuation Step)

After the formation of the precursor thin-film, the raw material gas that has not adsorbed onto the surface of the substrate is evacuated from the inside of the film formation chamber. In this case, it is ideal that the raw material gas be completely evacuated from the inside of the film formation chamber, but it is not always required that the raw material gas be completely evacuated. As an evacuation method, there are given, for example, a method involving purging the inside of a system in the film formation chamber with an inert gas, such as helium, nitrogen, or argon, a method involving performing evacuation by decompressing the inside of the system, and a combination of these methods. The decompression degree when decompression is performed falls within preferably the range of from 0.01 Pa to 300 Pa, more preferably the range of from 0.01 Pa to 100 Pa.

### (Metal-containing Thin-film Formation Step)

In the metal-containing thin-film formation step, after the evacuation step, the reactive gas is introduced into the film formation chamber, and a metal-containing thin-film is formed from the precursor thin-film formed in the previous precursor thin-film formation step by the action of the reactive gas or by the action of the reactive gas and the action of heat. When the reactive gas is an oxidizing gas, a gallium oxide thin-film or an indium oxide thin-film is formed. In this step, the temperature when the heat is applied is preferably from room temperature to 500°C, more preferably from 100°C to 400°C. The pressure of the system (in the film formation chamber) when this step is performed is preferably from 1 Pa to 10,000 Pa, more preferably from 10 Pa to 1,000 Pa. The thin-film forming raw material, which is used in an atomic layer deposition method, of the present invention has satisfactory reactivity with the oxidizing gas such as water vapor, and thus a high-quality metal-containing thin-film having a small residual carbon amount can be produced with high productivity.

Examples of the reactive gas include: oxidizing gases, including oxygen, ozone, nitrogen dioxide, nitrogen monoxide, water vapor, hydrogen peroxide, formic acid, acetic acid, and acetic anhydride; reducing gases, including hydrogen; and nitriding gases, including organic amine compounds, such as a monoalkylamine, a dialkylamine, a trialkylamine, and an alkylenediamine, hydrazine, and ammonia. Those reactive gases may be used alone or as a mixture thereof.

### (Other Evacuation Step)

After the formation of the above-mentioned metal-containing thin-film, the reactive gas that is unreacted and a by-product gas are evacuated from the inside of the film formation chamber. At this time, it is ideal that the reactive gas and the by-product gas be completely evacuated from the inside of the film formation chamber. However, it is not always required that the gases be completely evacuated. An evacuation method and a decompression degree when decompression is performed are the same as those of the evacuation step after the precursor thin-film formation step described above.

As described above, a metal-containing thin-film having a desired film thickness is produced as follows: the raw material gas introduction step, the precursor thin-film formation step, the evacuation step, the metal-containing thin-film formation step, and the other evacuation step are sequentially performed; deposition performed by the series of operations is defined as one cycle; and the cycle is repeated a plurality of times until a thin-film having a desired film thickness is obtained. In the method of producing a thin-film involving using an ALD method, the film thickness of the metal-containing thin-film to be formed may be controlled by the number of the cycles.

In addition, in the method of producing a thin-film of the present invention, energy, such as plasma, light, or a voltage, may be applied, and a catalyst may be used. There is no particular limitation on the timing for applying the energy and the timing for using the catalyst. The energy may be applied or the catalyst may be used, for example, at the time of introducing the raw material gas in the raw material introduction step, at the time of heating in the precursor thin-film formation step or the metal-containing thin-film formation step, at the time of evacuating the inside of the system in the evacuation step, or at the time of introducing the oxidizing gas in the metal-containing thin-film formation step, or between the above-mentioned respective steps.

In addition, in the method of producing a thin-film of the present invention, after the thin-film formation, annealing treatment may be performed in an inert atmosphere, an oxidizing atmosphere, or a reducing atmosphere in order to obtain more satisfactory electrical characteristics. When step embedding is required, a reflow step may be provided. The temperature in this case is preferably from 200°C to 1,000°C, more preferably from 250°C to 500°C.

As an apparatus for producing a thin-film through use of the thin-film forming raw material, which is used in an atomic layer deposition method, of the present invention, a well-known ALD apparatus may be used. As specific examples of the apparatus, there are given an apparatus capable of performing bubbling supply of a precursor as illustrated in FIG. 1 and an apparatus including a vaporization chamber as illustrated in FIG. 2. In addition, there is given an apparatus capable of subjecting the reactive gas to plasma treatment as illustrated in FIG. 3 and FIG. 4. The apparatus is not limited to single-substrate type apparatus as illustrated in FIG. 1 to FIG. 4, and an apparatus capable of simultaneously processing a large number of substrates through use of a batch furnace may also be used.

A thin-film produced through use of the thin-film forming raw material, which is used in an atomic layer deposition method, of the present invention may be formed as desired kinds of thin-films through the coating of a substrate made of, for example, a metal, oxide ceramics, nitride ceramics, or glass, by appropriately selecting the other precursor, the reactive gas, and the production conditions. The thin-film obtained by the present invention is excellent in electrical characteristics and optical characteristics, and hence may be widely used for the production of, for example, electrode materials for memory elements typified by DRAM elements, resistance films, diamagnetic films used in recording layers of hard disks, and catalyst materials for polymer electrolyte fuel cells.

### Examples

The present invention is described in more detail by way of Examples and the like. However, the present invention is not limited by the following Examples and the like.

### [Example 1] Synthesis of Compound No. 9

1.07 Grams (6.7 mmol) of trimethylindium and 15 ml of dehydrated tetrahydrofuran (THF) were loaded into a 100 ml three-necked flask at room temperature, and 1.05 g (6.7 mmol) of N-ethyl-N'-tert-butyl-propionamidine was dropped into the mixture under ice cooling, followed by stirring at room temperature for 19 hours. THF was evaporated in an oil bath at 70°C under slightly reduced pressure. After that, a pale yellow transparent liquid remaining in the flask was distilled under reduced pressure (40 Pa) to provide 0.92 g (3.1 mmol, yield: 46%) of a colorless transparent liquid as a distillate.

The resultant colorless transparent liquid was analyzed by ¹H-NMR and ICP-AES. As a result, the liquid was identified as Compound No. 9 that was a target compound. The analysis results of the resultant colorless transparent liquid are described below.

### (1) ¹H-NMR (deuterated benzene)

0.114 ppm (6H, singlet), 0.888-0.956 ppm (6H, multiplet), 1.108 ppm (9H, singlet), 2.009-2.065 (2H, quartet), 2.958-3.012 (2H, quartet)

### (2) Results of Elemental Analysis by ICP-AES

In: 38.31 mass% (theoretical value: 38.25 mass%), C: 44.00 mass% (theoretical value: 44.02 mass%), H: 8.41 mass% (theoretical value: 8.40 mass%), N: 9.28 mass% (theoretical value: 9.33 mass%)

### [Example 2] Synthesis of Compound No. 46

0.98 Gram (6.1 mmol) of trimethylindium and 15 ml of dehydrated THF were loaded into a 100 ml three-necked flask at room temperature, and 1.12 g (6.1 mmol) of dipivaloylmethane was dropped into the mixture under ice cooling, followed by stirring at room temperature for 20 hours. THF was evaporated in an oil bath at 70°C under slightly reduced pressure. After that, a pale yellow transparent liquid remaining in the flask was distilled under reduced pressure (50 Pa) to provide 1.32 g (4.0 mmol, yield: 66%) of a colorless transparent liquid as a distillate.

The resultant colorless transparent liquid was analyzed by ¹H-NMR and ICP-AES. As a result, the liquid was identified as Compound No. 46 that was a target compound. The analysis results of the resultant colorless transparent liquid are described below.

### (1) ¹H-NMR (deuterated benzene)

0.015 ppm (6H, singlet), 1.145 ppm (18H, singlet), 5.743 ppm (1H, singlet)

### (2) Results of Elemental Analysis by ICP-AES

In: 35.02 mass% (theoretical value: 34.99 mass%), C: 47.55 mass% (theoretical value: 47.58 mass%), H: 7.72 mass% (theoretical value: 7.68 mass%), O: 9.71 mass% (theoretical value: 9.75 mass%)

### [Example 3] Synthesis of Compound No. 66

0.81 Gram (7.1 mmol) of trimethylgallium and 15 ml of dehydrated THF were loaded into a 100 ml three-necked flask at room temperature, and 1.31 g (7.1 mmol) of dipivaloylmethane was dropped into the mixture under ice cooling, followed by stirring at room temperature for 20 hours. THF was evaporated in an oil bath at 70°C under slightly reduced pressure. After that, a pale yellow transparent liquid remaining in the flask was distilled under reduced pressure (50 Pa) to provide 1.25 g (4.4 mmol, yield: 62%) of a colorless transparent liquid as a distillate. The resultant colorless transparent liquid was analyzed by ¹H-NMR and ICP-AES. As a result, the liquid was identified as Compound No. 66 that was a target compound. The analysis results of the resultant colorless transparent liquid are described below.

### (1) ¹H-NMR (deuterated benzene)

0.052 ppm (6H, singlet), 1.061 ppm (18H, singlet), 5.735 ppm (1H, singlet)

### (2) Results of Elemental Analysis by ICP-AES

Ga: 24.64 mass% (theoretical value: 24.63 mass%), C: 55.11 mass% (theoretical value: 55.16 mass%), H: 8.91 mass% (theoretical value: 8.90 mass%), O: 11.34 mass% (theoretical value: 11.31 mass%)

The following evaluations were performed by using Compound No. 9 obtained in Example 1, Compound No. 46 obtained in Example 2, Comparative Compounds 1 and 2 shown in Table 1, and Comparative Compound 3 shown in Table 2.

### (1) Melting Point Evaluation

The state of each of the compounds at normal pressure and 25°C was visually observed, and the melting point of a solid compound was measured with a micro melting point-measuring device. The results are shown in Table 1 and Table 2.

### (2) Thermal Decomposition Start Temperature (°C)

The temperature at which the thermal decomposition of each of the test compounds started was evaluated by subjecting the test compound sealed in a closed container to differential scanning calorimetry (DSC) under the condition of a temperature increase rate of 10°C/min until its temperature reached 500°C. A lower thermal decomposition start temperature means that the test compound is poorer in thermal stability. The results are shown in Table 1 and Table 2.

**Table 1**

| Compound | Compound No. 9 | Comparative Compound 1 | Comparative Compound 2 |
|---|---|---|---|
| | 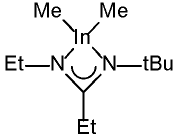 | 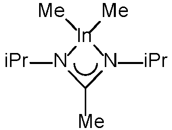 | 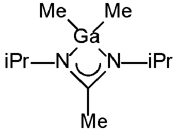 |
| Molecular weight | 300.15 | 286.13 | 241.03 |
| Melting point evaluation | Liquid | Liquid | Liquid |
| Thermal decomposition start temperature | 292°C | 230°C | 232°C |

**Table 2**

| Compound | Compound No. 46 | Comparative Compound 3 |
|---|---|---|
| | 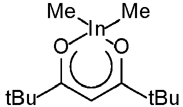 | 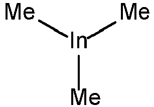 |
| Molecular weight | 328.16 | 159.92 |
| Melting point evaluation | Liquid | 88°C |
| Thermal decomposition start temperature | 346°C | 172°C |

The following evaluations were performed by using Compound No. 66 obtained in Example 3 and Comparative Compound 4 shown in Table 3.

### (1) Melting Point Evaluation

The melting point was measured under the same conditions as those of the melting point evaluation of each of Compound No. 9 and Compound No. 46. The results are shown in Table 3.

### (2) Temperature (°C) at Time of 50 Mass% Loss in Reduced-pressure TG-DTA

The weight of the test compound was measured with a TG-DTA at 10 Torr, an argon flow rate of 50 mL/min, and a temperature increase rate of 10°C/min in the scanning temperature range of from 30°C to 600°C, and a temperature (°C) when the weight of the test compound reduced by 50 mass% was evaluated as a "temperature (°C) at the time of a 50 mass% loss in reduced-pressure TG-DTA." A lower temperature (°C) at the time of a 50 mass% loss in reduced-pressure TG-DTA means that vapor is obtained at a lower temperature. The results are shown in Table 3.

### (3) Temperature (°C) at Time of 50 Mass% Loss in Normal-pressure TG-DTA

The weight of the test compound was measured with a TG-DTA at 760 Torr, an argon flow rate of 100 mL/min, and a temperature increase rate of 10°C/min in the scanning temperature range of from 30°C to 400°C, and a temperature (°C) when the weight of the test compound reduced by 50 mass% was evaluated as a "temperature (°C) at the time of a 50 mass% loss in normal-pressure TG-DTA." A lower temperature (°C) at the time of a 50 mass% loss in normal-pressure TG-DTA means that vapor is obtained at a lower temperature. The results are shown in Table 3.

### (4) Thermal Decomposition Start Temperature (°C)

The thermal decomposition start temperature was measured under the same conditions as those of the thermal decomposition start temperature measurement of each of Compound No. 9 and Compound No. 46. The results are shown in Table 3.

**Table 3**

| Compound | Compound No. 66 | Comparative Compound 4 |
|---|---|---|
| | 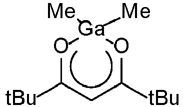 | 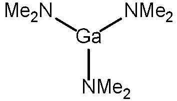 |
| Molecular weight | 283.06 | 201.95 |
| Melting point evaluation | Liquid | 103°C |
| Temperature at time of 50 mass% loss in reduced-pressure TG-DTA | 60°C | 123°C |
| Temperature at time of 50 mass% loss in normal-pressure TG-DTA | 130°C | 202°C |
| Thermal decomposition start temperature | 293°C | 223°C |

It was able to be recognized from the above-mentioned results that each of Compound No. 9, Compound No. 46, and Compound No. 66 had a thermal decomposition start temperature of 290°C or more, and was hence excellent in thermal stability. In addition, it was able to be recognized that Compound No. 66 showed a high vapor pressure, and was hence vaporized at a lower temperature because the compound had a temperature at the time of a 50 mass% loss in reduced-pressure TG-DTA of 60°C and a temperature at the time of a 50 mass% loss in normal-pressure TG-DTA of 130°C.

### [Example 4]

A thin-film was produced on the surface of a silicon wafer that was a substrate under the following conditions by using Compound No. 66 as a thin-film forming raw material, which is used in an atomic layer deposition method, and by using the ALD apparatus illustrated in FIG. 1. The composition of the thin-film was analyzed by using X-ray electron spectroscopy. As a result, it was recognized that the thin-film was a thin-film containing gallium oxide, and its residual carbon amount was smaller than 0.1 atom% that was a detection limit. In addition, the film thickness of the thin-film was measured by using scanning electron microscopy. As a result, the thin-film formed on the surface of the silicon wafer was a smooth film having a film thickness of 10 nm, and a film thickness obtained per cycle was about 0.02 nm.

### (Conditions)

Production method: ALD method
Reaction temperature (substrate temperature): 300°C
Reactive gas: Water vapor

### (Steps)

A series of steps formed of the following (1) to (4) was defined as one cycle, and the cycle was repeated 500 times.
(1) A raw material gas obtained by vaporizing a thin-film forming raw material, which is used in an atomic layer deposition method, under the conditions of a raw material container temperature of 40°C and a raw material container internal pressure of 100 Pa is introduced into a film formation chamber, and the raw material gas is caused to adsorb onto the surface of a substrate at a system pressure of 100 Pa for 10 seconds, to thereby form a precursor thin-film.
(2) The raw material gas that has not adsorbed onto the surface of the substrate is evacuated from the inside of the system through argon purging for 15 seconds.
(3) A reactive gas is introduced into the film formation chamber, and the precursor thin-film and the reactive gas are caused to react with each other at a system pressure of 100 Pa for 0.2 second.
(4) The reactive gas that is unreacted and a by-product gas are evacuated from the inside of the system through argon purging for 60 seconds.

### [Example 5]

A thin-film was produced on the surface of a silicon wafer that was a substrate under the following conditions by using Compound No. 9 as a thin-film forming raw material, which is used in an atomic layer deposition method, and by using the ALD apparatus illustrated in FIG. 1. The composition of the thin-film was analyzed by using X-ray electron spectroscopy. As a result, it was recognized that the thin-film was a thin-film containing indium oxide, and its residual carbon amount was smaller than 0.1 atom% that was a detection limit. In addition, the film thickness of the thin-film was measured by using scanning electron microscopy. As a result, the thin-film formed on the surface of the silicon wafer was a smooth film having a film thickness of 20 nm, and a film thickness obtained per cycle was about 0.04 nm.

### (Conditions)

Production method: ALD method
Reaction temperature (substrate temperature): 250°C
Reactive gas: Water vapor

### (Steps)

A series of steps formed of the following (1) to (4) was defined as one cycle, and the cycle was repeated 500 times.
(1) A raw material gas obtained by vaporizing a thin-film forming raw material, which is used in an atomic layer deposition method, under the conditions of a raw material container temperature of 50°C and a raw material container internal pressure of 100 Pa is introduced into a film formation chamber, and the raw material gas is caused to adsorb onto the surface of a substrate at a system pressure of 100 Pa for 10 seconds, to thereby form a precursor thin-film.
(2) The raw material gas that has not adsorbed onto the surface of the substrate is evacuated from the inside of the system through argon purging for 15 seconds.
(3) A reactive gas is introduced into the film formation chamber, and the precursor thin-film and the reactive gas are caused to react with each other at a system pressure of 100 Pa for 0.2 second.
(4) The reactive gas that is unreacted and a by-product gas are evacuated from the inside of the system through argon purging for 60 seconds.

### [Example 6]

A thin-film was produced on the surface of a silicon wafer that was a substrate under the following conditions by using Compound No. 46 as a thin-film forming raw material, which is used in an atomic layer deposition method, and by using the ALD apparatus illustrated in FIG. 1. The composition of the thin-film was analyzed by using X-ray electron spectroscopy. As a result, it was recognized that the thin-film was a thin-film containing indium oxide, and its residual carbon amount was smaller than 0.1 atom% that was a detection limit. In addition, the film thickness of the thin-film was measured by using scanning electron microscopy. As a result, the thin-film formed on the surface of the silicon wafer was a smooth film having a film thickness of 16 nm, and a film thickness obtained per cycle was about 0.03 nm.

### (Conditions)

Production method: ALD method
Reaction temperature (substrate temperature): 300°C
Reactive gas: Water vapor

### (Steps)

A series of steps formed of the following (1) to (4) was defined as one cycle, and the cycle was repeated 500 times.
(1) A raw material gas obtained by vaporizing a thin-film forming raw material, which is used in an atomic layer deposition method, under the conditions of a raw material container temperature of 50°C and a raw material container internal pressure of 100 Pa is introduced into a film formation chamber, and the raw material gas is caused to adsorb onto the surface of a substrate at a system pressure of 100 Pa for 10 seconds, to thereby form a precursor thin-film.
(2) The raw material gas that has not adsorbed onto the surface of the substrate is evacuated from the inside of the system through argon purging for 15 seconds.
(3) A reactive gas is introduced into the film formation chamber, and the precursor thin-film and the reactive gas are caused to react with each other at a system pressure of 100 Pa for 0.2 second.
(4) The reactive gas that is unreacted and a by-product gas are evacuated from the inside of the system through argon purging for 60 seconds.

### [Comparative Example 1]

A thin-film was produced on the surface of a silicon wafer that was a substrate under the same conditions as those of Example 4 except that: Comparative Compound 4 (tris(dimethylamino)gallium) was used as a thin-film forming raw material, which is used in an atomic layer deposition method; and the raw material container temperature was changed to 80°C. The composition of the thin-film was analyzed by using X-ray electron spectroscopy. As a result, the thin-film was a thin-film containing gallium oxide, but residual carbon was detected. In addition, the state of the thin-film was observed by using scanning electron microscopy. As a result, the thin-film formed on the surface of the silicon wafer was not smooth, and hence its film thickness could not be measured.

It was recognized from the foregoing that the thin-film forming raw material, which is used in an atomic layer deposition method, of the present invention showed excellent thermal stability and a high vapor pressure. It was recognized that a high-quality metal-containing thin-film was able to be produced by using the thin-film forming raw material, which is used in an atomic layer deposition method, of the present invention.

## Claims

1. A thin-film forming raw material, which is used in an atomic layer deposition method, comprising a compound represented by the following general formula (1): 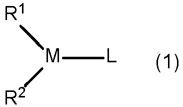 where R¹ and R² each independently represent a hydrogen atom or an alkyl group having 1 to 5 carbon atoms, L represents a group represented by the following general formula (L-1) or (L-2), and M represents an indium atom or a gallium atom, and part or all of hydrogen atoms in the alkyl group may each be substituted with a fluorine atom; 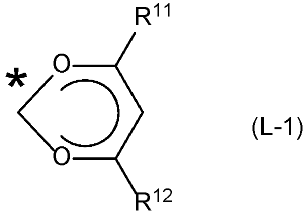 where R¹¹ and R¹² each independently represent a hydrogen atom, a fluorine atom, an alkyl group having 1 to 5 carbon atoms, or an alkoxy group having 1 to 5 carbon atoms, and * represents a bonding position with M in the general formula (1), and part or all of hydrogen atoms in the alkyl group may each be substituted with a fluorine atom; 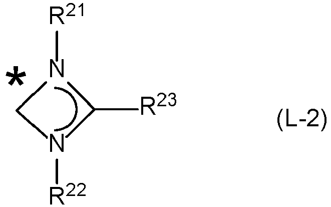 where R²¹ to R²³ each independently represent a hydrogen atom, a fluorine atom, or an alkyl group having 1 to 5 carbon atoms, and * represents a bonding position with M in the general formula (1), provided that R²¹ and R²² represent different groups, and part or all of hydrogen atoms in the alkyl group may each be substituted with a fluorine atom.

2. The thin-film forming raw material, which is used in an atomic layer deposition method, according to claim 1, wherein R¹ and R² represent methyl groups.

3. A method of producing a thin-film containing an indium atom or a gallium atom on a surface of a substrate, the method comprising the steps of:
adsorbing the compound in a raw material gas, which is obtained by vaporizing the thin-film forming raw material, which is used in an atomic layer deposition method, of claim 1 or 2, onto the surface of the substrate, to form a precursor thin-film; and
subjecting the precursor thin-film to a reaction with a reactive gas, to form the thin-film containing an indium atom or a gallium atom on the surface of the substrate.

4. The method of producing a thin-film according to claim 3, wherein the reactive gas is an oxidizing gas, and the thin-film is an indium oxide thin-film or a gallium oxide thin-film.

5. The method of producing a thin-film according to claim 4, wherein the oxidizing gas is a gas containing oxygen, ozone, or water vapor.

6. The method of producing a thin-film according to claim 4 or 5, wherein the step of subjecting the precursor thin-film to a reaction with the reactive gas is performed at a temperature within a range of from 100°C to 400°C.
